# FASCICULE DE BREVET EUROPEEN

(11) **EP 3 920 091 B1**
(45) Date de publication et mention de la délivrance du brevet: **21.02.2024**
(21) Numéro de dépôt: 21177485.6
(22) Date de dépôt: 02.06.2021
(51) Int. Cl.: G06V 40/13

(54) **MODULE DE CAPTEUR BIOMÉTRIQUE POUR CARTE À PUCE ET PROCÉDÉ DE FABRICATION D'UN TEL MODULE**
BIOMETRISCHES SENSORMODUL FÜR CHIPKARTE UND VERFAHREN ZUR HERSTELLUNG EINES SOLCHEN MODULS
BIOMETRIC SENSOR MODULE FOR A SMART CARD AND METHOD FOR MANUFACTURING SUCH A MODULE

(30) Priorité: 04.06.2020 FR 2005877
(43) Date de publication de la demande: 08.12.2021
(73) Titulaire: Linxens Holding, 78200 Mantes-la-Jolie (FR)
(72) Inventeur: MATHIEU, Christophe, 78200 Mantes-la-Jolie (FR); LAURENS DE LOPEZ, Claire, 78200 Mantes-la-Jolie (FR); GERMAIN, Sébastien, 78200 Mantes-la-Jolie (FR)
(74) Mandataire: INNOV-GROUP

(56) Documents cités:
- EP-A1- 3 336 759
- WO-A1-2017/164791
- US-A1- 2018 181 738

## Description

### Domaine technique

L'invention concerne le domaine de la carte à puce.

### Etat de la technique

Dans le domaine de la carte à puce, et notamment dans celui des cartes à puce utilisées comme moyen de paiement, les fabricants souhaitent offrir aux utilisateurs toujours davantage de sécurité et/ou de facilité d'utilisation. Ainsi, il a été proposé d'intégrer, à des cartes à puce, des capteurs biométriques pour la lecture d'empreintes digitales. Pour détecter des empreintes digitales, de tels capteurs comprennent un élément de détection formé d'un ensemble d'éléments sensibles (par exemple capacitifs), agencés en général en lignes et colonnes sous une zone de détection.

Pour les cartes bénéficiant de modes de lecture avec et sans contact, un module intégré à la carte et comprenant un capteur biométrique peut permettre de n'autoriser une transaction que si l'empreinte digitale du titulaire de la carte est détectée. Ce type de carte est par exemple décrit dans les documents de brevet publiés sous les numéros US 2018/181738 A1, WO 2017/164791 A1 et EP 3 336 759 A1. Pour réaliser une telle carte, une cavité est fraisée dans la carte, pour mettre à nu un circuit électrique préalablement intégré dans le corps de la carte, et y loger le module. Le module alors logé dans cette cavité est aussi électriquement connecté au circuit.

Il a été constaté que la zone de détection sur laquelle doit être posé un doigt, pour que l'empreinte digitale soit reconnue, est soumise à un certain nombre de facteurs (humidité, sueur, abrasion mécanique, vieillissement UV, température, etc.) susceptibles de détériorer et/ou d'user prématurément l'élément de détection. Il peut être envisagé de recouvrir la surface de la zone de détection d'une couche protectrice. Mais il faut alors trouver un matériau qui à la fois permet d'accroitre la résistance aux facteurs agressifs auxquels est soumise la zone de détection, permet également de ne pas perturber la détection de l'empreinte digitale, mais est aussi compatible avec l'ensemble des autres étapes de fabrication, de traitement et d'encartage du module biométrique.

L'invention vise à trouver une solution permettant d'améliorer au moins partiellement la protection de la zone de détection, et si possible sans sacrifier l'esthétique de la zone de détection visible en surface de la carte.

### Résumé de l'invention

Ainsi il est proposé selon l'invention un module de capteur biométrique pour carte à puce, comprenant
- un substrat diélectrique comportant une face externe et une face interne, situées chacune respectivement de part et d'autre de ce substrat diélectrique considéré selon son épaisseur, les faces interne et externe du substrat correspondant aux faces principales du substrat,
- des pistes et des plots de connexion réalisés dans un feuillet de matériau électriquement conducteur reposant sur la face interne du substrat et étant fixé à celle-ci,
- un capteur biométrique avec un élément de détection formé d'éléments sensibles, ce capteur étant connecté à au moins certains plots, et étant fixé sur une zone de la face interne dépourvue de matériau électriquement conducteur, une zone de la face externe située en vis-à-vis de l'élément de détection, correspondant à une zone de détection biométrique, et
- un encapsulant déposé au moins sur le capteur, du côté de la face interne du substrat.

En outre, dans ce module, au moins sur la zone de détection, la face externe du substrat correspond à un matériau polymère homogène, nu et ayant une température de transition vitreuse supérieure ou égale à 110 degrés Celsius.

En effet, un matériau polymère homogène, contrairement au verre-époxy par exemple ne comporte pas de fibres susceptibles de perturber la mesure biométrique qu'elle soit capacitive, optique, ultrasonique ou thermique. Par exemple, ce matériau polymère homogène est un polyimide, un polyéthylène naphthalate (PEN), une PolyEtherEtherKetone (PEEK). Par ailleurs, le fait d'avoir une température de transition vitreuse supérieure à 110°Celsius permet de mettre en oeuvre certaines techniques et matériaux de soudure et/ou connexion (ex : pâte à souder, soudure, film conducteur anisotrope - ACF ou Anisotropic conductive film en anglais - etc.) pour la connexion électrique entre le module de capteur biométrique et un circuit électrique intégré dans le corps de la carte à puce, ainsi que la mise en oeuvre de certains procédés d'assemblage et/ou d'encartage comprenant des étapes avec chauffage. De préférence, ce matériau polymère homogène est opaque et par exemple de couleur noire.

Le matériau polymère homogène est résistant mécaniquement (par exemple à l'abrasion d'un doigt posé de manière répétée sur la zone de détection). Le matériau polymère homogène est aussi résistant chimiquement (par exemple à la sueur acide ou basique, mais aussi aux solvants comme le fuel, l'éthanol, ou autres solvants mentionnés dans la norme ISO10373-1). Le matériau polymère homogène a une permittivité diélectrique relative, à température ambiante et à 1kHz, par exemple de l'ordre de 2 à 4 et préférentiellement comprise entre 3 et 3,5. Le substrat diélectrique peut être intégralement constitué d'une même couche du même matériau polymère homogène. Dans ce cas, son épaisseur est comprise par exemple entre 25 et 75 micromètres (par exemple, 50 micromètres). Ce mode de réalisation, permet d'utiliser un seul matériau pour protéger les éléments sensibles du capteur et pour réaliser le substrat formant le support pour le capteur et pour les connexions du capteur à un circuit électrique situé dans le corps de la carte à puce. Alternativement, si le substrat diélectrique est constitué de plusieurs couches, ledit matériau polymère homogène laissé à nu au moins sur la zone de détection recouvre la surface de la face externe correspondant à cette zone de détection. Lorsque le substrat diélectrique est constitué de plusieurs couches de matériau polymère homogène, ces différentes couches ont avantageusement la même permittivité diélectrique relative, ou des permittivités diélectriques relatives voisines et comprises entre 2 et 4, à température ambiante et à 1KHz, et préférentiellement comprises entre 3 et 3,5 à température ambiante et à 1KHz.

Le matériau polymère homogène peut être teinté dans la masse, notamment en noir, pour apporter une touche esthétique sur la carte. Ainsi, la couche de matériau polymère homogène protège les éléments sensibles de l'élément de détection, sans perturber la capture d'empreinte, tout en permettant d'apporter une éventuelle plus-value esthétique. La couche de matériau polymère homogène fournit ces avantages sans qu'il soit nécessaire d'ajouter une autre couche de protection sur la surface externe du substrat par exemple.

Ce module de carte à puce comprend éventuellement l'une et/ou l'autre des caractéristiques suivantes, considérées chacune indépendamment l'une de l'autre, ou chacune en combinaison d'une ou plusieurs autres :
- le capteur est fixé sur la face interne du substrat diélectrique, à l'aide d'une couche d'adhésif dont l'épaisseur est comprise entre 5 et 35 micromètres ; et
- le module comporte des premiers plots de connexion électriquement reliés au capteur qui se trouvent sous l'encapsulant et des deuxièmes plots de connexion reliés électriquement aux premiers plots de connexion, ces deuxièmes plots étant destinés à une connexion du module à un circuit de carte à puce, et se trouvant hors de l'encapsulant.

Selon un autre aspect, l'invention concerne une carte à puce comprenant un module de capteur biométrique selon l'invention. Cette carte à puce comprend un corps de carte avec un circuit électrique intégré dans le corps de carte. Le module et le circuit sont électriquement connectés l'un à l'autre à l'aide d'un matériau de soudure, déposé sur des plots de connexion.

Selon encore un autre aspect, l'invention concerne un procédé de fabrication d'un module de capteur biométrique pour carte à puce comprenant des étapes au cours desquelles
- on fournit un substrat diélectrique comportant une face externe et une face interne, situées chacune respectivement de part et d'autre de ce substrat diélectrique considéré selon son épaisseur, les faces interne et externe du substrat correspondant aux faces principales du substrat,
- on réalise des pistes et des plots de connexion dans un feuillet de matériau électriquement conducteur avant ou après que cette couche de matériau électriquement conducteur ait été fixée sur la face interne du substrat,
- on fixe sur une zone de la face interne dépourvue de matériau électriquement conducteur un capteur biométrique avec un élément de détection formé d'éléments sensibles, une zone de la face externe située en vis-à-vis de l'élément de détection, correspondant à une zone de détection biométrique,
- on connecte le capteur à au moins certains plots, et
- on encapsule le capteur dans un encapsulant.

En outre, au moins sur la zone de détection, la face externe du substrat correspond à un matériau polymère homogène laissé à nu.

### Brève description des figures

D'autres aspects, buts et avantages de l'invention apparaîtront à la lecture de la description détaillée qui suit, ainsi qu'à l'aide des dessins annexés, donnés à titre d'exemples non-limitatifs et sur lesquels :
[Fig.1] représente schématiquement en perspective une carte à puce conforme à un exemple de mode de réalisation de l'invention ;
[Fig.2a] à [Fig.2d] représentent schématiquement en coupe, différentes étapes d'un exemple de procédé de fabrication d'un module de capteur biométrique tel que celui intégré à la carte représentée sur la figure 1 ; et
[Fig.3] représente schématiquement en coupe, l'intégration dans une carte, d'un module de capteur biométrique obtenu à l'aide d'un procédé tel que celui illustré par les figures 2a à 2d.

### Description détaillée

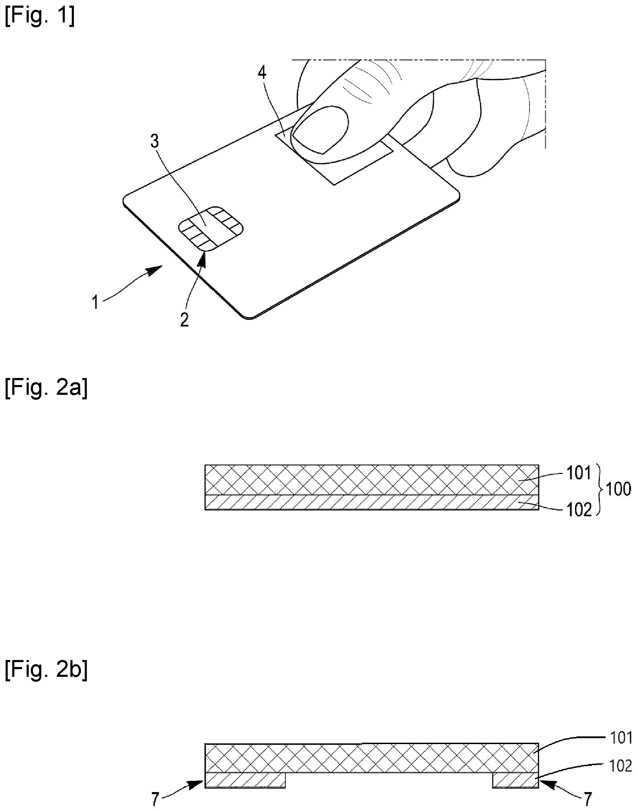

Un exemple de carte à puce 1 selon l'invention est représenté sur la figure 1. Selon cet exemple, la carte 1 est une carte bancaire au format ID-1. Cette carte 1 comporte un premier module 2 comprenant un connecteur 3 et une puce électronique (sous le connecteur). Le connecteur 3 permet de connecter électriquement la puce électronique à un lecteur de cartes, pour échanger des données entre la puce et le lecteur de cartes.

Dans le cas des cartes à double interface, c'est-à-dire permettant une lecture par contact ou sans contact, cette carte 1 comporte également une antenne intégrée dans le corps de la carte 1. Cette antenne est connectée par exemple à la puce située dans le premier module 2. Cette antenne permet d'échanger sans contact des données entre la puce et un lecteur de cartes sans contact. Cette antenne, ou une autre partie d'un circuit électrique situé dans le corps de la carte 1, est également connectée électriquement à un deuxième module 4 intégré à la carte 1. Le deuxième module 4 est un module biométrique. Ce module biométrique 4 comprend un capteur pour la reconnaissance d'empreintes digitales. Le deuxième module 4 permet de déterminer si l'empreinte digitale lue par le capteur correspond à celle d'un utilisateur qui a l'autorisation de se servir de cette carte 1. Dans ce cas, une communication sans contact entre la puce et un lecteur peut être autorisée.

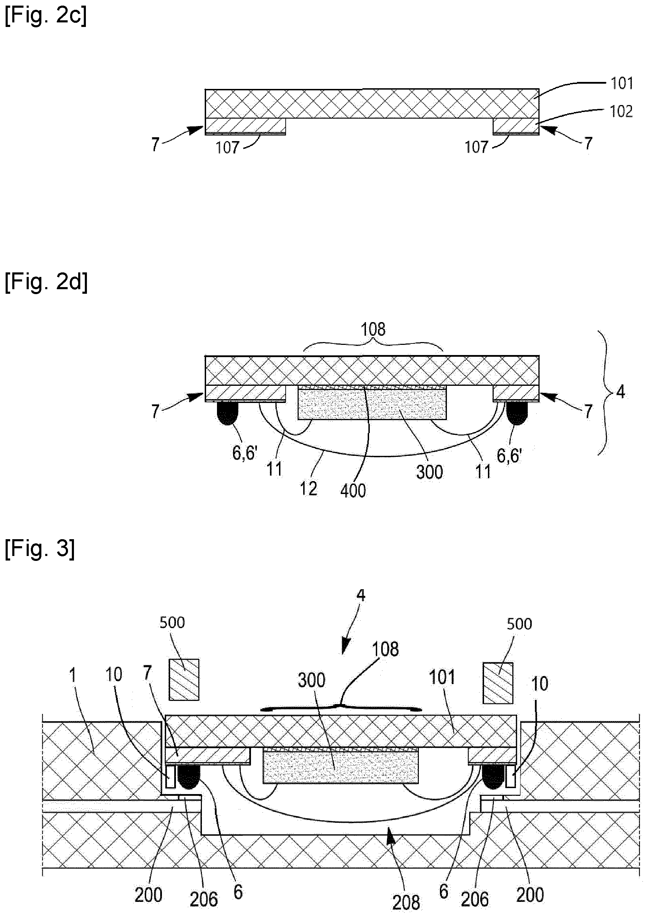

Un exemple de procédé de fabrication d'un module du type de celui illustré sur la figure 2 est décrit ci-dessous.

Ce procédé comprend la fourniture d'un matériau complexe 100 comprenant un substrat 101 en matériau diélectrique sur lequel est laminé un feuillet constitué d'un matériau électriquement conducteur 102 (voir figure 2a). Par exemple le matériau diélectrique est un polyimide dont l'épaisseur est comprise entre 25 et 75 micromètres, et est préférentiellement égale à 50 micromètres et le premier matériau électriquement conducteur 102 est constitué de cuivre ou d'un alliage de cuivre dont l'épaisseur est comprise entre 12 et 70 micromètres, et est préférentiellement égale à 18 micromètres ; pour une mise en oeuvre du procédé selon l'invention performante au plan industriel, ce matériau complexe 100 est avantageusement fourni en rouleau et le procédé est mis en oeuvre de rouleau à rouleau (« reel-to-reel » en anglais). Le matériau complexe 100 peut être fourni sous forme d'un stratifié (« clad » en anglais ; par exemple un stratifié cuivré ou « copper clad » en anglais). Alternativement, il peut être fourni sous la forme d'un complexe 100 multicouche (non-représenté) comprenant un substrat de matériau diélectrique 101, un feuillet de matériau électriquement conducteur 102, et une couche de matériau adhésif (par exemple de type epoxy) entre le substrat de matériau diélectrique 101 et le feuillet de matériau électriquement conducteur 102. Le matériau adhésif a par exemple une épaisseur comprise entre 10 et 25 micromètres. Ce complexe 100 multicouche subit une lamination. Le matériau adhésif subit éventuellement un procédé de séchage en continu pour évacuer les solvants présents dans la formulation au moment de son dépôt. La couche de matériau adhésif permet ainsi de fixer le feuillet de matériau électriquement conducteur 102 sur la face interne du substrat de matériau diélectrique 101. La lamination peut éventuellement être suivie d'une étape de réticulation thermique du matériau adhésif.

Le polyimide constitutif du substrat 101 est par exemple un polyimide thermostable (tel qu'un polyimide aromatique). Il s'agit par exemple du Kapton^{®} B Black commercialisé par DuPont^{™} ou du Kymide^{®} KYPI-B commercialisé par Kying^{®}.

Suivent ensuite des étapes d'un procédé de photolithogravure permettant de réaliser des plots et des pistes de connexion 7 (voir figure 2b), dans le feuillet de matériau électriquement conducteur 102. Ces étapes comprennent par exemple une étape de lamination d'un film sec de résine photosensible sur la surface libre du feuillet de matériau électriquement conducteur 102, puis l'insolation de ce film de résine photosensible à travers un masque, la révélation de la résine photosensible et la gravure sur certaines zones du feuillet matériau électriquement conducteur 102, pour former des plots de connexion, des pistes de connexion ou tout autre motif 7.

Alternativement, des plots et des pistes de connexion 7 sont réalisés par découpe ou gravure dans le feuillet de matériau électriquement conducteur 102 (selon la technologie dite « leadframe » en anglais), avant de les laminer sur la face interne du substrat diélectrique 101.

Avantageusement, peuvent être réalisés des dépôts électrolytiques de couches de métaux 107 (cuivre, nickel, or, palladium, argent et leurs alliages par exemple) destinés à faciliter la soudure de fils de connexion 11 sur le matériau électriquement conducteur 102 (voir figure 2c). D'autres technologies envisageables pour la connexion du capteur 300 aux plots et pistes de connexion 7 peuvent aussi nécessiter une ou plusieurs étapes de métallisation.

Plus particulièrement, les plots et les pistes de connexion 7 forment un circuit comprenant des premiers plots de connexion électriquement reliés au capteur 300 qui se trouvent sous un encapsulant 12 et des deuxièmes plots de connexion reliés électriquement aux premiers plots de connexion, ces deuxièmes plots étant destinés à une connexion du module 4 à un circuit 200 de carte à puce. Ces deuxièmes plots se trouvent hors de l'encapsulant 12 (voir plus loin la description en relation avec la figure 2d). Les premiers et deuxièmes plots sont éventuellement reliés par des pistes conductrices pour établir la continuité électrique nécessaire entre l'intérieur et l'extérieur de l'encapsulant 12.

Selon un mode particulier de mise en oeuvre du procédé selon l'invention, on réalise un dépôt d'un matériau de soudure 6 sur des plots de connexion 7 réalisés au cours des étapes précédentes dans le feuillet du matériau électriquement conducteur 102 (voir figure 2d). Par exemple le matériau de soudure 6 est un alliage d'étain-bismuth ou d'étain-bismuth-argent.

Alternativement, au lieu de déposer un matériau de soudure 6 sur les plots de connexion 7, ils sont laissés vierges, jusqu'à l'opération d'encartage du module 4 dans la carte 1. Alors, lors de l'opération d'encartage, préalablement à la mise en place du module 4 dans la cavité 208 ménagée (par exemple par fraisage) dans le corps de carte, un matériau de soudure 6, une pâte ou un film conducteur anisotrope 6' est déposé sur les plots de connexion 7, afin d'établir une connexion avec le circuit 200 logé dans le corps de carte (voir figure 3).

A l'issue des étapes ci-dessus, on obtient un rouleau comprenant des supports de capteur biométrique pour carte à puce. Chacun de ces supports a une structure correspondant par exemple à celle représentée sur la figure 2d. Chaque support comprend donc :
- Une face externe avec une zone de détection 108 située en vis-à-vis d'une zone de la face interne au niveau de laquelle reposeront les éléments sensibles d'un élément de détection d'un capteur biométrique ;
- Une face interne avec des plots de connexion 7, éventuellement avec une goutte d'un matériau de soudure 6 déposée sur au moins certains de ces plots de connexion 7 afin de pouvoir connecter ultérieurement un module 4 à un circuit 200 intégré dans le corps de carte (voir figure 3).

En vue de son utilisation et de son intégration dans une carte à puce 1, chaque support est muni d'un capteur biométrique 300 d'empreintes digitales. Avantageusement, le capteur biométrique 300 n'est pas ou peu sensible aux charges électrostatiques. On peut ainsi se dispenser de bézel. Le procédé décrit ci-dessus est alors beaucoup simplifié par rapport aux procédés de l'art antérieur au cours desquels un bézel doit être réalisé sur la face externe puis électriquement relié (par exemple à l'aide de vias conducteurs) à un circuit situé sur la face interne.

Ce capteur biométrique 300 est fixé sur la face arrière, par exemple, par une technologie connue de fixage de puce (« die attach » en anglais). Par exemple, on fixe le capteur biométrique 300 sur la face arrière du support 101 à l'aide d'un adhésif thermodurcissable 400 à des températures comprises entre 100°C et 150°C et qui possède la caractéristique de migrer par capillarité sous la totalité de la surface du capteur sans générer de vide, ni de bulles (« underfill » en anglais). Par exemple, l'épaisseur de l'adhésif thermodurcissable 400 sous le capteur biométrique 300 est comprise entre 5 et 35 micromètres. Par exemple, il s'agit d'un adhésif avec une base amine, sans époxy.

Le dépôt d'un matériau de soudure 6 sur des plots de connexion 7 est réalisé avant ou après assemblage du capteur biométrique 300, mais préférentiellement après pour éviter, lors de la réticulation de l'adhésif thermodurcissable 400, la fusion du matériau de soudure 6 notamment si celui-ci est un matériau de soudure à basse température.

Le matériau de soudure 6 est déposé par sérigraphie ou par jet (« jetting » en anglais). Préférentiellement, le dépôt du matériau de soudure 6 sur des plots de connexion 7 est réalisé par jet si le capteur biométrique 300 est déjà assemblé sur le support diélectrique 101.

Le capteur biométrique 300 occupe, sur la face arrière, une surface correspondant essentiellement à une aire de détection située, sur la face interne du substrat diélectrique 101, en vis-à-vis de la zone de détection 108. Ce capteur biométrique 300 est connecté aux plots de connexion 7 à l'aide d'une technologie connue, telle que la connexion par fils conducteurs 11 (« wire bonding » en anglais) comme représenté sur les figures 2d et 3. Alternativement, le capteur biométrique 300 est connecté aux plots de connexion 7 à l'aide de la technologie de la puce renversée (« flip chip » en anglais). Avantageusement, le capteur biométrique 300 et ses éventuels fils conducteurs 11 sont protégés dans l'encapsulant 12, par exemple constitué d'une résine d'encapsulation. Un adhésif thermofusible 10 (« hot melt » en anglais) est, éventuellement, également disposé en face arrière sur, ou à côté, des plots de connexion 7. Cet adhésif thermofusible 10 est destiné à fixer le module 4 de capteur biométrique dans la cavité 208 ménagée dans le corps d'une carte à puce (voir figure 3).

Lors de l'encartage du module 4 dans un corps de carte, pour établir une connexion entre les plots de connexion 7 du module 4 et le circuit 200 qui est intégré dans le corps de carte, plusieurs options sont possibles. On peut par exemple souder directement les plots de connexion 7 au circuit 200 à l'aide du matériau de soudure 6 déposé sur les plots de connexion 7. Alternativement, on peut déposer sur le circuit 200 des gouttes 206 d'un matériau de soudure et réaliser une connexion entre les plots de soudure 7 et le circuit 200 par fusion de l'un, de l'autre, ou des deux matériaux de soudure ayant été préalablement déposés, chacun respectivement, sur les plots de connexion 7 et sur le circuit 200. Plus particulièrement, par exemple on peut déposer un premier matériau de soudure 6 sur les plots de connexion 7 et un deuxième matériau de soudure 206 sur le circuit 200. Le premier matériau de soudure 6 est alors avantageusement un matériau de soudure ayant une basse température de fusion (par exemple une température de fusion inférieure ou égale à 140°C), le deuxième matériau de soudure 206 ayant avantageusement une température de fusion voisine ou identique à celle du premier matériau de soudure 6.

Par exemple, pour réaliser la connexion des plots de connexion 7 avec le circuit 200, on place une thermode 500 en vis-à-vis des plots de connexion 7 de part et d'autre du support 101.

En utilisant un premier matériau de soudure 6 à basse température de fusion (inférieure ou égale à 140°C) sur les plots de connexion 7 et un deuxième matériau de soudure 206, sur le circuit 200, ayant une température de fusion égale, voisine, ou inférieure, à celle du premier matériau de soudure 6, la thermode 400, chauffée par exemple à une température de 230°C est appliquée pendant 1.5 secondes. Le procédé selon est donc, dans ce cas, plus rapide. En outre, l'utilisation de matériaux de soudure 6, 206 à basse température de fusion, permet de mettre en oeuvre une thermode 400 avec une surface portante plus limitée, ce qui peut contribuer à mieux maitriser le fluage et à limiter les risques de déformation de la carte 1 et/ou du module 4. Ce procédé utilisant une soudure 206 basse température est avantageux par exemple pour les corps de carte en PVC lorsque la température de lamination du circuit 200 dans la carte avec sa soudure 206 ne dépasse pas 130°C.

En utilisant un premier matériau de soudure 6 à basse température de fusion (inférieure ou égale à 140°C) sur les plots de connexion 7 et un deuxième matériau de soudure 206 à plus haute température sur le circuit 200, la thermode 400, chauffée par exemple à une température de 230°C est appliquée pendant 2,5 secondes. La chaleur fournie par la thermode 400 diffuse également au niveau de l'adhésif thermofusible 10 pour coller le module 4 dans la carte 1.

Ce procédé utilisant un matériau de soudure 206 à haute température de fusion est avantageux par exemple pour les corps de carte en polycarbonate lorsque la température de lamination du circuit 200 dans la carte avec sa soudure 206 peut aller jusqu'à 190°C.

D'une manière générale, pour connecter le module 4 au circuit 200, on peut utiliser une colle ou pâte électriquement conductrice 6', un film anisotrope conducteur ou un matériau de soudure 6. Mais dans tous les cas, avantageusement, on utilise le procédé décrit ci-dessus ou des variantes de celui-ci, en réalisant des plots de connexion 7 ayant une forme compatible aussi bien avec l'utilisation d'un matériau de soudure 6, qu'avec une pâte ou un film conducteur anisotrope 6', cette forme pouvant être rectangulaire, en losange, carrée, un ovale, ou en forme de disque, avec en outre des extensions radiales ou latérales. Le module 4 selon l'invention est alors le même qu'il soit connecté par soudure ou à l'aide d'un adhésif conducteur. Cela permet de fabriquer le module 4 en plus grandes séries tout en laissant la possibilité à l'encarteur de choisir l'une ou l'autre des technologies de connexion.

Pour des raisons esthétiques et/ou pour indiquer où se trouver la zone de détection sur laquelle il faut placer le doigt pour en détecter l'empreinte, le substrat diélectrique 101 est avantageusement teinté dans la masse. Par exemple, le substrat diélectrique 101 est un polyimide teinté en noir, à l'aide d'un pigment ou d'un colorant.

## Revendications

1. Module de capteur biométrique pour carte à puce (1), comprenant
- un substrat diélectrique (101) comportant une face externe et une face interne, situées chacune respectivement de part et d'autre de ce substrat diélectrique (101) considéré selon son épaisseur, les faces interne et externe du substrat diélectrique (101) correspondant aux faces principales de celui-ci,
- des pistes et des plots de connexion (7) réalisés dans un feuillet de matériau électriquement conducteur (102) reposant sur la face interne du substrat diélectrique (101) et étant fixé à celle-ci,
- un capteur biométrique (300) avec un élément de détection formé d'éléments sensibles, ce capteur (300) étant connecté à au moins certains plots de connexion (7), et étant fixé sur une zone de la face interne dépourvue de matériau électriquement conducteur, une zone de la face externe située en vis-à-vis de l'élément de détection, correspondant à une zone de détection biométrique (108) configurée pour qu'un doigt posé dessus établisse un contact avec celle-ci, et
- un encapsulant (12) déposé au moins sur le capteur (300), du côté de la face interne du substrat diélectrique (101),
**caractérisé par le fait qu'**au moins sur la zone de détection (108), la face externe du substrat diélectrique (101) correspond à un matériau polymère homogène nu et ayant une température de transition vitreuse supérieure ou égale à 110 degrés Celsius.

2. Module selon la revendication 1, dans lequel le substrat diélectrique (101) est constitué du matériau polymère homogène laissé à nu au moins sur la zone de détection (108).

3. Module selon la revendication 1 ou 2, dans lequel le matériau polymère homogène est choisi parmi les matériaux suivants : un polyimide, un polyéthylène naphthalate, PEN, et une PolyEtherEtherKetone.

4. Module selon l'une des revendications précédentes, dans lequel le matériau polymère homogène a une épaisseur comprise entre 25 et 75 micromètres, et a une épaisseur voisine de 50 micromètres.

5. Module selon l'une des revendications précédentes, dans lequel le matériau polymère homogène est teinté dans la masse.

6. Module selon l'une des revendications précédentes, dans lequel le capteur (300) est fixé sur la face interne du substrat diélectrique (101), à l'aide d'une couche d'adhésif (400) dont l'épaisseur est comprise entre 5 et 35 micromètres.

7. Module selon l'une des revendications précédentes, comportant des premiers plots de connexion électriquement reliés au capteur (300) qui se trouvent sous l'encapsulant (12) et des deuxièmes plots de connexion reliés électriquement aux premiers plots de connexion, ces deuxièmes plots étant destinés à une connexion du module (4) à un circuit (200) de carte à puce, et se trouvant hors de l'encapsulant (12).

8. Module selon l'une des revendications précédentes, dans lequel la face externe ne comporte pas de bézel entourant la zone de détection (108).

9. Carte à puce comprenant un corps de carte avec un circuit (200) électrique intégré dans le corps de carte et un module (4) selon l'une des revendications précédentes, le module (4) et le circuit (200) étant électriquement connectés à l'aide d'un matériau de soudure (6, 6') déposé sur les deuxièmes plots de connexion.

10. Procédé de fabrication d'un module (4) de capteur biométrique pour carte à puce (1), comprenant des étapes au cours desquelles
- on fournit un substrat diélectrique (101) comportant une face externe et une face interne, situées chacune respectivement de part et d'autre de ce substrat diélectrique (101) considéré selon son épaisseur, les faces interne et externe du substrat diélectrique (101) correspondant aux faces principales de celui-ci,
- on réalise des pistes et des plots de connexion (7) dans un feuillet de matériau électriquement conducteur (102) avant ou après que ce feuillet de matériau électriquement conducteur (102) ait été fixé sur la face interne du substrat diélectrique (101),
- on fixe sur une zone de la face interne dépourvue de matériau électriquement conducteur un capteur biométrique (300) avec un élément de détection formé d'éléments sensibles, une zone de la face externe située en vis-à-vis de l'élément de détection, correspondant à une zone de détection (108) biométrique configurée pour qu'un doigt posé dessus établisse un contact avec celle-ci,
- on connecte le capteur (300) à au moins certains plots (7), et
- on encapsule le capteur (300) dans un encapsulant (12), **caractérisé par le fait qu'**au moins sur la zone de détection (108), la face externe du substrat diélectrique (101) correspond à un matériau polymère homogène nu et ayant une température de transition vitreuse supérieure ou égale à 110 degrés Celsius.

## Patentansprüche

1. Biometrisches Sensormodul für eine Chipkarte (1), das enthält
- ein dielektrisches Substrat (101), das eine Außenseite und eine Innenseite aufweist, die sich je zu beiden Seiten dieses dielektrischen Substrats (101) gemäß seiner Dicke betrachtet befinden, wobei die Innen- und Außenseiten des dielektrischen Substrats (101) dessen Hauptseiten entsprechen,
- Bahnen und Anschlussklötzchen (7), die je in einer elektrisch leitenden Materialschicht (102) hergestellt sind, die auf der Innenseite des dielektrischen Substrats (101) ruht und an diesem befestigt ist,
- einen biometrischen Sensor (300) mit einem von empfindlichen Elementen gebildeten Erkennungselement, wobei dieser Sensor (300) an mindestens bestimmte Anschlussklötzchen (7) angeschlossen und an einem Bereich der Innenseite befestigt ist, der kein elektrisch leitendes Material aufweist, wobei ein Bereich der Außenseite, der sich gegenüber dem Erkennungselement befindet, einem biometrischen Erkennungsbereich (108) entspricht, der konfiguriert ist, damit ein darauf aufgelegter Finger einen Kontakt mit ihm herstellt, und
- einen Verkapselungsstoff (12), der auf der Seite der Innenseite des dielektrischen Substrats (101) mindestens auf den Sensor (300) aufgebracht ist,
**dadurch gekennzeichnet, dass** mindestens im Erkennungsbereich (108) die Außenseite des dielektrischen Substrats (101) einem blanken homogenen Polymermaterial entspricht, das eine Glasübergangstemperatur höher als oder gleich 110 Grad Celsius hat.

2. Modul nach Anspruch 1, wobei das dielektrische Substrat (101) aus dem homogenen Polymermaterial besteht, das mindestens auf dem Erkennungsbereich (108) blank gelassen wird.

3. Modul nach Anspruch 1 oder 2, wobei das homogene Polymermaterial aus den folgenden Materialien ausgewählt wird: ein Polyimid, ein Polyethylennaphthalat, PEN, und ein Polyetheretherketon.

4. Modul nach einem der vorhergehenden Ansprüche, wobei das homogene Polymermaterial eine Dicke zwischen 25 und 75 Mikrometer hat, und eine Dicke nahe 50 Mikrometer hat.

5. Modul nach einem der vorhergehenden Ansprüche, wobei das homogene Polymermaterial durchgefärbt ist.

6. Modul nach einem der vorhergehenden Ansprüche, wobei der Sensor (300) an der Innenseite des dielektrischen Substrats (101) mit Hilfe einer Kleberschicht (400) befestigt ist, deren Dicke zwischen 5 und 35 Mikrometer liegt.

7. Modul nach einem der vorhergehenden Ansprüche, das elektrisch mit dem Sensor (300) verbundene erste Anschlussklötzchen, die sich unter dem Verkapselungsstoff (12) befinden, und zweite Anschlussklötzchen aufweist, die elektrisch mit den ersten Anschlussklötzchen verbunden sind, wobei diese zweiten Klötzchen für einen Anschluss des Moduls (4) an eine Chipkartenschaltung (200) bestimmt sind und sich außerhalb des Verkapselungsstoffs (12) befinden.

8. Modul nach einem der vorhergehenden Ansprüche, wobei die Außenseite keine den Erkennungsbereich (108) umgebende Einfassung aufweist.

9. Chipkarte, die einen Kartenkörper mit einer in den Kartenkörper integrierten elektrischen Schaltung (200) und ein Modul (4) nach einem der vorhergehenden Ansprüche enthält, wobei das Modul (4) und die Schaltung (200) mit Hilfe eines Schweißmaterials (6, 6') elektrisch angeschlossen sind, das auf die zweiten Anschlussklötzchen aufgebracht ist.

10. Verfahren zur Herstellung eines biometrischen Sensormoduls (4) für eine Chipkarte (1), das Schritte enthält, während denen
- ein dielektrisches Substrat (101) bereitgestellt wird, das eine Außenseite und eine Innenseite aufweist, die sich je zu beiden Seiten dieses dielektrischen Substrats (101) gemäß seiner Dicke betrachtet befinden, wobei die Innen- und Außenseiten des dielektrischen Substrats (101) dessen Hauptseiten entsprechen,
- Bahnen und Anschlussklötzchen (7) in einer elektrisch leitenden Materialschicht (102) hergestellt werden, bevor oder nachdem diese elektrisch leitende Materialschicht (102) an der Innenseite des dielektrischen Substrats (101) befestigt wurde,
- auf einem Bereich der Innenseite ohne elektrisch leitendes Material ein biometrischer Sensor (300) mit einem aus empfindlichen Elementen gebildeten Erkennungselement befestigt wird, wobei ein Bereich der dem Erkennungselement gegenüber befindlichen Außenseite einem biometrischen Erkennungsbereich (108) entspricht, der konfiguriert ist, damit ein darauf aufgelegter Finger einen Kontakt mit diesem aufbaut,
- der Sensor (300) an mindestens bestimmte Klötzchen (7) angeschlossen wird, und
- der Sensor (300) in einem Verkapselungsstoff (12) verkapselt wird,
**dadurch gekennzeichnet, dass** mindestens im Erkennungsbereich (108) die Außenseite des dielektrischen Substrats (101) einem blanken homogenen Polymermaterial entspricht, das eine Glasübergangstemperatur höher als oder gleich 110 Grad Celsius hat.

## Claims

1. Biometric sensor module for a chip card (1), comprising
- a dielectric substrate (101) having an outer face and an inner face, each situated respectively on either side of this dielectric substrate (101) considered along its thickness, the inner and outer faces of the dielectric substrate (101) corresponding to the main faces thereof,
- tracks and connection pads (7) formed in a sheet of electrically conductive material (102) that rests on the inner face of the dielectric substrate (101) and is fastened thereto,
- a biometric sensor (300) with a detection element formed of sensitive elements, this sensor (300) being connected to at least some connection pads (7), and being fastened to an area of the inner face that does not have any electrically conductive material, an area of the outer face situated opposite the detection element corresponding to a biometric detection area (108) configured such that a finger placed on it establishes contact therewith, and
- an encapsulation (12) deposited at least on the sensor (300), on the side of the inner face of the dielectric substrate (101),
**characterized in that**, at least over the detection area (108), the outer face of the dielectric substrate (101) corresponds to a homogeneous polymer material that is exposed and that has a glass transition temperature greater than or equal to 110 degrees Celsius.

2. Module according to Claim 1, wherein the dielectric substrate (101) consists of the homogeneous polymer material left exposed at least over the detection area (108).

3. Module according to Claim 1 or 2, wherein the homogeneous polymer material is chosen from among the following materials: a polyimide, a polyethylene naphthalate, PEN, and a polyetheretherketone.

4. Module according to one of the preceding claims, wherein the homogeneous polymer material has a thickness between 25 and 75 micrometres, and has a thickness close to 50 micrometres.

5. Module according to one of the preceding claims, wherein the homogeneous polymer material is bulk-coloured.

6. Module according to one of the preceding claims, wherein the sensor (300) is fastened to the inner face of the dielectric substrate (101) using an adhesive layer (400) the thickness of which is between 5 and 35 micrometres.

7. Module according to one of the preceding claims, having first connection pads that are electrically connected to the sensor (300) and that are located underneath the encapsulation (12) and second connection pads that are electrically connected to the first connection pads, these second pads being intended to connect the module (4) to a chip card circuit (200) and being located outside the encapsulation (12).

8. Module according to one of the preceding claims, wherein the outer face does not have a bezel surrounding the detection area (108).

9. Chip card comprising a card body with an electrical circuit (200) integrated into the card body and a module (4) according to one of the preceding claims, the module (4) and the circuit (200) being electrically connected using a solder material (6, 6') deposited on the second connection pads.

10. Method for manufacturing a biometric sensor module (4) for a chip card (1), comprising steps of
- providing a dielectric substrate (101) having an outer face and an inner face, each situated respectively on either side of this dielectric substrate (101) considered along its thickness, the inner and outer faces of the dielectric substrate (101) corresponding to the main faces thereof,
- forming tracks and connection pads (7) in a sheet of electrically conductive material (102) before or after this sheet of electrically conductive material (102) has been fastened to the inner face of the dielectric substrate (101),
- fastening a biometric sensor (300) with a detection element formed of sensitive elements to an area of the inner face that does not have any electrically conductive material, an area of the outer face situated opposite the detection element corresponding to a biometric detection area (108) configured such that a finger placed on it establishes contact therewith,
- connecting the sensor (300) to at least some pads (7), and
- encapsulating the sensor (300) in an encapsulation (12),
**characterized in that**, at least over the detection area (108), the outer face of the dielectric substrate (101) corresponds to a homogeneous polymer material that is exposed and that has a glass transition temperature greater than or equal to 110 degrees Celsius.
